(19) **Europäisches Patentamt / European Patent Office / Office européen des brevets**

(11) **EP 1 916 763 A1**

(12) **EUROPEAN PATENT APPLICATION**

(43) Date of publication:
**30.04.2008 Bulletin 2008/18**

(51) Int Cl.:
***H03C 5/00*** (2006.01)

(21) Application number: **07011820.3**

(22) Date of filing: **15.06.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK RS** | (72) Inventors:<br>• **Frantzeskakis, Emmanouil**<br>  **Ilioupolis (GR)**<br>• **Sfikas, Georgios**<br>  **Glyfada (GR)** |
| (30) Priority: **24.10.2006 US 552181** | (74) Representative: **Jehle, Volker Armin**<br>**Bosch Graf von Stosch Jehle**<br>**Patentanwaltsgesellschaft mbH**<br>**Flüggenstrasse 13**<br>**80639 München (DE)** |
| (71) Applicant: **Broadcom Corporation**<br>**Irvine, CA 92617 (US)** | |

(54) **Method and system for digital tracking in direct and polar modulation**

(57)    Aspects of a method and system for digital tracking in direct and polar modulation are presented. Aspects of the system may include at least one circuit within a phase locked loop (PLL) circuit that enables adaptive and digital control of an analog fractional N (Frac N) PLL during direct modulation of a signal or polar modulation of the signal.

**FIG. 1A**

EP 1 916 763 A1

## EP 1 916 763 A1

**Description**

CROSS-REFERENCE TO RELATED APPLICATIONS/INCORPORATION BY REFERENCE

NOT APPLICABLE.

FIELD OF THE INVENTION

Certain embodiments of the invention relate to wireless communication. More specifically, certain embodiments of the invention relate to a method and system for digital tracking in direct and polar modulation.

BACKGROUND OF THE INVENTION

Mobile communications have changed the way people communicate and mobile phones have been transformed from a luxury item to an essential part of every day life. The use of mobile phones today is dictated by social situations, rather than hampered by location or technology. While voice connections fulfill the basic need to communicate, and wireless voice and data connections continue to filter even further into the fabric of every day life, various integrated mobile multimedia applications, utilizing wireless and/or wired networks, may be the next step in the mobile communication revolution.

Third generation (3G) cellular networks offering various high speed access technologies and mobile telephones that have been specifically designed to utilize these technologies, fulfill demands for integrated multimedia applications supporting TV and audio applications utilizing advanced compression standards, high-resolution gaming applications, musical interfaces, peripheral interface support, etc. The processing requirements are being increased as chip designers take advantage of compression and higher bandwidths to transmit more information. 3G wireless applications support bit rates from 384 kilobits (Kbits)/second to 2 megabits (Mbits)/second, allowing chip designers to provide wireless systems with multimedia capabilities, superior quality, reduced interference, and a wider coverage area.

As mobile multimedia services grow in popularity and usage, factors such as power consumption, cost efficient optimization of network capacity and quality of service (QoS) continue to be even more essential to cellular operators than it is today. These factors may be achieved with careful network planning and operation, improvements in transmission methods, and advances in receiver techniques and chip integration solutions. To this end, carriers need technologies that will allow them to increase downlink throughput for the mobile multimedia applications support and, in turn, offer advanced QoS capabilities and speeds for consumers of mobile multimedia application services. Currently, mobile multimedia processors may not fully utilize system-on-a-chip (SoC) integration for advanced total system solution for today's mobile handsets. For example, conventional mobile processors may utilize a plurality of hardware accelerators to enable a variety of multimedia applications, which significantly increases power consumption, implementation complexity, mobile processor real estate, and ultimately terminal size.

Some mobile communications technologies, for example the global system for mobile communications (GSM), general packet radio service (GPRS), and enhanced data rates for GSM evolution (EDGE) may utilize direct or polar modulation. Polar modulation may comprise converting a signal from a representation that utilizes in-phase (I), and quadrature phase (Q) components, to a corresponding representation that utilizes magnitude ($\rho$) and phase ($\varphi$) components. Quantization noise may be introduced as a result of the conversion from the I and Q signal representation to the $\rho$ and $\varphi$ signal representation. Consequently, at least a portion of the components in the $\rho$ and $\varphi$ signal representation may be filtered.

There are numerous existing integrated circuit (IC) designs for direct modulation and/or polar modulation transmitters that are based on fractional-N phase locked loop (PLL) and/or sigma delta modulation techniques. Many of these IC designs comprise mixed analog and digital signals for which CMOS technology may be a semiconductor fabrication technology of choice for maintaining low power consumption and manufacturing cost. However, variations in component parameter values introduced during IC manufacturing, and temperature variations introduced during circuit operation may require that analog component values be adjustable, or tunable, to control component behavior. A particular area of concern is a low pass filtering characteristic that is typical in many PLL designs. This may pose a particular problem when a cutoff frequency of the low pass filter is within the range of frequencies utilized by a direct modulation and/or polar modulation transmitter for transmitting signals. As a result, an input signal that is being modulated by the direct modulation or polar modulation transmitter may become distorted. In turn, the modulation output signal may become distorted. The result is that the transmitted signal, when received at a receiver device, may not present a faith reproduction of the original input signal that was submitted for transmission.

In some existing direct modulation and/or polar modulation transmitters analog component values in PLL circuitry may be tunable by utilizing analog control circuitry. However, one limitation of the use of analog control circuitry to control analog PLL circuitry may be component mismatches between components in the analog PLL circuitry that have a direct impact on the system performance. A limitation associated with the use of such circuitry in polar modulation transmitters may be the introduction of timing misalignment between the phase signal path, and the amplitude signal path for the input signals to the polar modulation transmitter.

Further limitations and disadvantages of conventional and traditional approaches will become apparent to one of skill in the art, through comparison of such systems with some aspects of the present invention as set forth in the remainder of the present application with reference to the drawings.

BRIEF SUMMARY OF THE INVENTION

A method and system for digital tracking in direct and polar modulation, substantially as shown in and/or described in connection with at least one of the figures, as set forth more completely in the claims.

According to an aspect of the invention, a method for processing signals in a circuit is provided, the method comprising: adaptively and digitally controlling an analog phase locked loop (PLL) during direct modulation of a signal or polar modulation of said signal.

Advantageously, said analog PLL comprises at least a portion of at least one of: an integer-N PLL, an integer-N synthesizer, a fractional-N PLL, a fractional-N synthesizer, a delta-sigma fractional-N PLL, a delta-sigma fractional-N synthesizer, a hybrid PLL, and a hybrid synthesizer.

Advantageously, the method further comprises generating a digital waveform of said signal for said adaptive and digital controlling.

Advantageously, the method further comprises generating said digital control signal based on a value of an objective function that is computed based on said digital waveform and said signal.

Advantageously, the method further comprises minimizing said objective function by utilizing at least one of: a least mean square algorithm, a conjugate descent algorithm, and a recursive least squares algorithm.

Advantageously, the method further comprises generating a digital control signal based on an analog feedback signal generated within said analog PLL circuit, wherein said generated digital control signal is utilized for said adaptive and digital controlling.

Advantageously, the method further comprises generating said analog feedback signal based on a control voltage input signal to a voltage control oscillator (VCO) within said analog PLL.

Advantageously, the method further comprises generating an output signal by a frequency divider circuit within said analog PLL for said adaptive and digital controlling.

Advantageously, said adaptive and digital controlling comprises adjusting at least one of: a VCO gain factor, a charge pump gain factor, a PLL bandwidth parameter, a PLL control gain parameter, a feedback gain parameter, a capacitance value, and a resistance value.

Advantageously, said adaptive and digital controlling comprises adjusting at least one coefficient in a parametric equalizer circuit.

Advantageously, the method further comprises configuring at least one of: a pass band gain parameter, a filter rolloff parameter, a center frequency parameter, a filter bandwidth parameter, within said parametric equalizer circuit based on said at least one coefficient.

Advantageously, said parametric equalizer circuit comprises a digital circuit that comprises one of: a finite impulse response filter, and an infinite impulse response filter.

According to an aspect of the invention, a system for processing signals in a circuit is provided, the system comprising: at least one circuit that enables adaptive and digital control of an analog phase locked loop (PLL) during direct modulation of a signal or polar modulation of said signal.

Advantageously, said analog PLL comprises at least a portion of at least one of: an integer-N PLL, an integer-N synthesizer, a fractional-N PLL, a fractional-N synthesizer, a delta-sigma fractional-N PLL, a delta-sigma fractional-N synthesizer, a hybrid PLL, and a hybrid synthesizer.

Advantageously, said at least one circuit enables generation of a digital waveform of said signal for said adaptive and digital control.

Advantageously, said at least one circuit enables generation of said digital control signal based on a value of an objective function that is computed based on said digital waveform and said signal.

Advantageously, said at least one circuit enables minimization of said objective function by utilizing at least one of: a least mean square algorithm, a conjugate descent algorithm, and a recursive least squares algorithm.

Advantageously, said at least one circuit enables generation of a digital control signal based on an analog feedback signal generated within said analog PLL circuit, wherein said generated digital control signal is utilized for said adaptive and digital control.

Advantageously, said at least one circuit enables generation of said analog feedback signal based on a control voltage input signal to a voltage control oscillator (VCO) within said analog PLL.

Advantageously, said at least one circuit enables generation of an output signal by a frequency divider circuit within said analog PLL for said adaptive and digital control.

Advantageously, said adaptive and digital control comprises adjustment of at least one of: a VCO gain factor, a charge pump gain factor, a PLL bandwidth parameter, a PLL control gain parameter, a feedback gain parameter, a capacitance value, and a resistance value.

Advantageously, said adaptive and digital control comprises adjustment of at least one coefficient in a parametric equalizer circuit.

Advantageously, said at least one circuit enables configuration of at least one of: a pass band gain parameter, a filter rolloff parameter, a center frequency parameter, a filter bandwidth parameter, within said parametric equalizer circuit based on said at least one coefficient.

Advantageously, said parametric equalizer circuit comprises a digital circuit that comprises one of: a finite impulse response filter, and an infinite impulse response filter.

These and other advantages, aspects and novel features of the present invention, as well as details of an illustrated embodiment thereof, will be more fully understood from the following description and drawings.

BRIEF DESCRIPTION OF SEVERAL VIEWS OF THE DRAWINGS

FIG. 1A is a block diagram illustrating an exemplary mobile terminal, in accordance with an embodiment of the invention.

FIG. 1B is a block diagram illustrating an exemplary polar modulation transmitter, which may be utilized in connection with an embodiment of the invention.

FIG. 2A is a block diagram of an exemplary analog PLL with digital tracking, in accordance with an embodiment of the invention.

FIG. 2B is a diagram illustrating exemplary A/D signal conversion, which may be utilized in connection with an embodiment of the invention.

FIG. 3 is a block diagram of an exemplary analog PLL with digital tracking, in accordance with an embodiment of the invention.

FIG. 4 is a block diagram of an exemplary digitally controlled analog Fractional N (Frac N) PLL, in accordance with an embodiment of the invention.

FIG. 5A is a block diagram of an exemplary digitally controlled analog Fractional N (Frac N) PLL incorporating a parametric equalizer, in accordance with an embodiment of the invention.

FIG. 5B is a block diagram of an exemplary digitally controlled parametric equalizer circuit, in accordance with an embodiment of the invention.

FIG. 6 is a block diagram of an exemplary analog Fractional N (Frac N) PLL incorporating a parametric equalizer that is digitally controlled based on a feedback signal , in accordance with an embodiment of the invention.

FIG. 7 is a block diagram of an exemplary analog Fractional N (Frac N) PLL that is digitally controlled based on an internal feedback signal, in accordance with an embodiment of the invention.

FIG. 8 is a flowchart illustrating exemplary steps for digital tracking control of an analog circuit, in accordance with an embodiment of the invention.

FIG. 9 is a chart illustrating PLL feedback frequency response as a function of $K_v$, which may be utilized in connection with an embodiment of the invention.

FIG. 10A is a diagram illustrating exemplary acquisition of data based on a step response, which may be utilized in connection with an embodiment of the invention.

FIG. 10B is a diagram illustrating exemplary values of a measurement statistic, which may be utilized in connection with an embodiment of the invention.

DETAILED DESCRIPTION OF THE INVENTION

Certain embodiments of the invention relate to a method and system for digital tracking in direct and polar modulation. In various embodiments of the invention, analog component values in an analog PLL circuit may be controlled based on a digital control input signal that may be generated by digital control circuitry based on an analog feedback signal generated within the analog PLL circuit. The analog feedback signal may be continuously detected, or monitored, by the digital control circuitry with subsequent digital control signals generated based on current analog feedback signals. The continuous monitoring and generation of digital control signals in response to current analog feedback signals may be referred to as digital tracking. In this regard, various embodiments of the invention comprise a method and system for digital tracking of analog PLL circuitry. For analog PLL circuitry, which is utilized in a direct modulation transmitter, or polar modulation transmitter, various embodiments of the invention may relate to a method and system for digital tracking in direct and polar modulation transmitters. Utilizing digital tracking control of analog fractional-N PLL designs may enable fabrication of these PLL designs utilizing high integrated very large scale integration (VLSI) IC fabrication technologies where analog component values may be very sensitive to variations introduced during IC manufacturing, and/or to temperature induced variations during circuit operation.

Various embodiments of the invention may be utilized in a range of wireless communications systems, such as frequency modulation (FM) transmitters, Bluetooth systems, ZigBee systems, digitally enhanced cordless telecommunications (DECT) systems, global system for mobile communications (GSM) systems, enhanced data for GSM evolution (EDGE) systems, and wideband code division multiple access (WCDMA) systems, for example. Various embodiments of the invention may also be utilized in software defined radio (SDR) architectures.

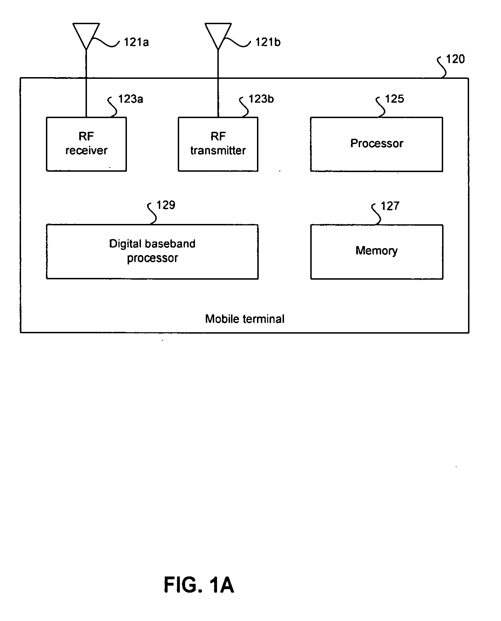

FIG. 1A is a block diagram illustrating an exemplary mobile terminal, in accordance with an embodiment of the invention. Referring to FIG. 1A, there is shown a mobile terminal 120 that may comprise an RF receiver 123a, an RF transmitter 123b, a digital baseband processor 129, a processor 125, and a memory 127. A receive antenna 121 a may be communicatively coupled to the RF receiver 123a. A transmit antenna 121 b may be communicatively coupled to the RF transmitter 123b.

The RF receiver 123a may comprise suitable logic, circuitry, and/or code that may enable processing of received RF signals. The RF receiver 123a may enable receiving RF signals in a plurality of frequency bands. The RF receiver 123a may enable receiving signals in cellular frequency bands, for example, GSM, GPRS, and/or EDGE. Each frequency band supported by the RF receiver 123a may have a corresponding front-end circuit for handling low noise amplification and down conversion operations, for example.

The RF receiver 123a may down convert the received RF signal to a baseband frequency signal that comprises an in-phase (I) component and a quadrature (Q) component. In some instances, the RF receiver 123a may enable analog-to-digital conversion of the baseband signal components before transferring the components to the digital baseband processor 129.

The digital baseband processor 129 may comprise suitable logic, circuitry, and/or code that may enable processing and/or handling of baseband frequency signals. In this regard, the digital baseband processor 129 may process or handle signals received from the RF receiver 123a and/or signals to be transferred to the RF transmitter 123b. The digital baseband processor 129 may also provide control and/or feedback information to the RF receiver 123a and to the RF transmitter 123b based on information from the processed signals. The digital baseband processor 129 may communicate information and/or data from the processed signals to the processor 125 and/or to the memory 127. Moreover, the digital baseband processor 129 may receive information from the processor 125 and/or to the memory 127, which may be processed and transferred to the RF transmitter 123b.

The RF transmitter 123b may comprise suitable logic, circuitry, and/or code that may enable processing of RF signals for transmission via a wireless medium. The RF transmitter 123b may enable transmission of RF signals in a plurality of frequency bands. Moreover, the RF transmitter 123b may enable transmission of signals in cellular frequency bands, for example. Each frequency band supported by the RF transmitter 123b may have a corresponding front-end circuit for handling amplification and/or up conversion operations, for example.

The RF transmitter 123b may convert the baseband frequency signal comprising I/Q components to a signal comprising phase and/or amplitude components, which may then be up converted to an RF signal. In some instances, the RF transmitter 123b may enable digital-to-analog conversion of the baseband signal components received from the digital baseband processor 129 before up conversion.

The processor 125 may comprise suitable logic, circuitry, and/or code that may enable control and/or data processing operations for the mobile terminal 120. The processor 125 may be utilized to control at least a portion of the RF receiver 123a, the RF transmitter 123b, the digital baseband processor 129, and/or the memory 127. In this regard, the processor 125 may generate at least one signal for controlling operations within the mobile terminal 120. The processor 125 may also enable execution of applications that may be utilized by the mobile terminal 120.

The memory 127 may comprise suitable logic, circuitry, and/or code that may enable storage of data and/or other information utilized by the mobile terminal 120. For example, the memory 127 may be utilized for storing processed data generated by the digital baseband processor 129 and/or the processor 125. The memory 127 may also be utilized to store information, such as configuration information, that may be utilized to control the operation of at least one block in the mobile terminal 120.

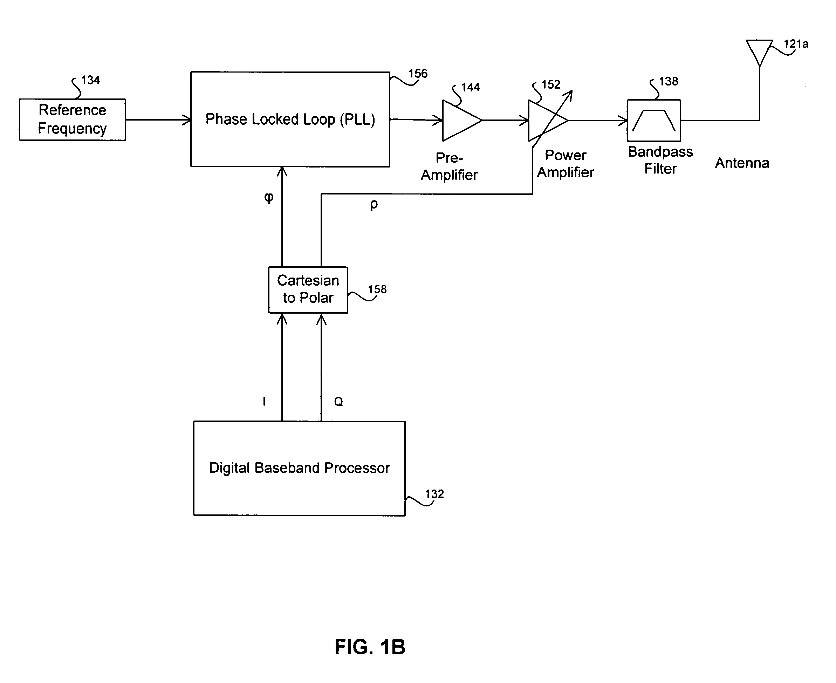

FIG. 1B is a block diagram illustrating an exemplary polar modulation transmitter, which may be utilized in connection with an embodiment of the invention. Referring to FIG. 1 B, there is shown a digital baseband processor 132, a reference frequency block 134, a power amplifier 152, a bandpass filter 138, a transmit antenna 121b, a phase locked loop (PLL) 156, a preamplifier 144, and a Cartesian to polar conversion block 158. The polar modulation transmitter, as illustrated in FIG. 1B, may be part of a mobile terminal, such as the mobile terminal 120 in FIG. 1A, for example.

The reference frequency block 134 may comprise suitable logic, circuitry, and/or code that may enable generation of local oscillator (LO) and/or carrier frequency signals. The reference frequency block 134 may comprise a crystal, which may be utilized for generating the LO signals.

The digital baseband processor 132 may comprise suitable logic, circuitry, and/or code that may enable processing and/or handling of baseband frequency signals. The digital baseband processor may generate a digital baseband signal comprising in-phase (I) and quadrature phase (Q) components. The digital baseband signal may comprise a plurality of samples and each sample may comprise a plurality of bits, for example 12 bits. The samples within the digital baseband signal may occur at a sampling rate, for example 13 MHz. Each sample in the baseband digital signal, which may represent a plurality of signal levels, for example $2^{12}$, or 4,096, signal levels.

The bandpass filter 138 may comprise suitable logic, circuitry, and/or code that may enable generation of an output signal by processing and input signal to attenuate input signal amplitudes for a range of electromagnetic frequencies below a low frequency, $f_{LOW}$, and above a high frequency, $f_{HIGH}$. The range of frequencies that are greater than or equal to $f_{LOW}$ and less than or equal to $f_{HIGH}$ may comprise a pass band.

The preamplifier 144 may comprise suitable logic, circuitry, and/or code that may enable generation of an output signal whose signal level comprises a fixed or variable attenuation in comparison to a signal level associated with a corresponding input signal.

The power amplifier 152 may comprise suitable logic, circuitry, and/or code that may enable generation of an output signal, based on an input signal, with sufficient electrical power, that amplitude associated with the output signal may be maintained when the output signal is applied to an electrical load. The power amplifier 152 may be characterized by a linear operation when a change in amplitude for the input signal corresponds to a proportional change in amplitude for the output signal. The gain associated with the power amplifier 152 may be variable based on a received gain control input signal.

The Cartesian to polar conversion block 158 may comprise suitable logic, circuitry, and/or code that may enable generation of magnitude and phase components corresponding to a received input signal. The Cartesian to polar conversion block 158 may receive a digital baseband signal comprising I and Q components. The Cartesian to polar conversion block 158 may generate a representation of the digital baseband signal that comprises a magnitude ($\rho$) component, and a phase ($\varphi$) component. The magnitude component may represent amplitude modulated signal component, and the phase component may represent a phase modulated signal component.

The fractional-N synthesizer 156 may comprise suitable logic, circuitry, and/or code that may enable utilization of the phase modulated signal component to generate a synthesized RF signal. The fractional-N synthesizer 156 may generate the synthesized RF signal based on an input IF signal. The fractional-N synthesizer 156 may generate a change in signal level and/or frequency for the synthesized RF signal based on a corresponding change in the input IF signal. The fractional-N synthesizer 156 may perform calibration and pre-distortion procedures to equalize the corresponding change across a range of frequencies, substantially as described for the fractional-N synthesizer 142.

In operation, the digital baseband processor 132 may provide a baseband signal comprising I and Q signal components. The I and Q signal components may be communicated to the Cartesian to polar conversion block 158. The Cartesian to polar conversion block 158 may generate magnitude ($\rho$) and phase ($\varphi$) signal components, which correspond to the received I and Q signal components. The phase signal component may be communicated to the PLL 156. The PLL 156 may utilize the phase signal component, and the LO signal and/or carrier frequency signal from the reference frequency block 134; to generate an RF synthesized signal. The frequency associated with the RF synthesized signal may be based on the carrier frequency derived from an input signal received from the reference frequency block 134.

The preamplifier 144 may modify the amplitude associated with the RF synthesized signal. The amplitude modified RF synthesized signal may comprise an output RF synthesized signal. The power amplifier 136 may modify the amplitude associated with the output RF synthesized signal. The power amplifier 136 may modify the amplitude associated with the output RF synthesized signal based on the magnitude component signal, received from the Cartesian to polar conversion block 158. The output RF synthesized signal may comprise signal components that span a range of frequencies. The bandpass filter 138 may band limit the amplified output RF synthesized signal by reducing signal levels for signal components associated with frequencies that are not within the pass band for the bandpass filter 138. The transmit antenna 121 b may enable the band limited signal to be transmitted via a wireless medium.

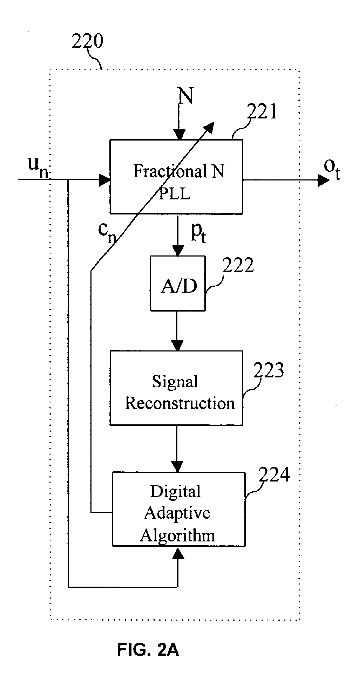

FIG. 2A is a block diagram of an exemplary analog PLL with digital tracking, in accordance with an embodiment of the invention. Referring to FIG. 2A, there is shown a PLL 220. In an exemplary polar modulation transmitter, such as shown in FIG. 1B, the PLL 220 may be exemplary of the PLL 156. The PLL 220 may comprise an analog Fractional N PLL block 221, an analog to digital converter (A/D) block 222, a signal reconstruction block 223, and a digital adaptive algorithm block 224.

The analog Fractional N (Frac N) PLL block 221 may comprise suitable logic, circuitry, and/or code that may enable generation of an analog output signal, $o_t$, based on a digital input signal $u_n$. In a direct modulation transmitter circuit, or in a polar modulation transmitter circuit, the output signal $o_t$ may comprise a frequency modulated (FM) signal having a frequency, $F(u_n)$, that is determined based on the input signal $u_n$. The output signal $o_t$ may comprise an analog signal. In a direct modulation circuit, the input signal $u_n$ may comprise a digital baseband signal. In a polar modulation circuit, the input signal $u_n$ may comprise a phase component, such as may be generated by a Cartesian to polar conversion block 158. The center frequency of the transmitted signal and the granularity with which the frequency $F(u_n)$ may change in response to a change in $u_n$ may be determined based on a reference frequency, $F_{Ref}$, and the input N to the analog Frac N PLL block 221. The reference frequency may be generated internally within the Frac N PLL block 221 by, for example, a reference frequency block 134 (FIG. 1 B). The input N may represent a frequency division number, which may comprise non-integer values.

The A/D block 222 may comprise suitable logic, circuitry, and/or code that may enable generation of a digital output signal $p_n$ based on an analog input signal $p_t$. The A/D block 222 may measure convert analog information, such as a signal amplitude, into a form suitable for digital processing, such as a sequence of bytes, or samples, corresponding to a sequence of signal amplitude measurements taken at distinct time instants. The A/D conversion process may comprise acquisition, quantization, and encoding. Acquisition may comprise sampling the analog input signal to derive a measurement of the signal amplitude, or an acquired signal level, at a distinct time instant. Quantization may comprise dividing a signal measurement range into distinct signal levels, or quantization levels, and mapping the acquired signal level to one of the quantized levels. Encoding may comprise converting the quantization level to a digital representation comprising one or more bits. The A/D block may utilize any of a variety of encoding techniques, such as μ-law or A-law algorithms, for example.

The signal reconstruction block 223 may comprise suitable logic, circuitry, and/or code that may enable generation of a digitized waveform approximating the digital input signal $u_n$. The digitized waveform may represent a sequence of quantization levels at distinct time instants that correspond to the sequence of samples in the digital input signal.

The digital adaptive algorithm block 224 may comprise suitable logic, circuitry, and/or code that may enable generation of a digital control output signal, $c_n$, based on a digitized waveform signal, and an input signal $u_n$. The digital adaptive algorithm block 224 may generate the digital control output signal based on a comparison between the digitized waveform signal and the input signal.

In operation, the analog Frac N PLL block 221 may receive an input signal, $u_n$, and an input N. An initial value for the digital control input signal, $c_n$, may be generated based on a calibration procedure performed prior to the initiation of normal operation for the analog Frac N PLL block 221. The analog Frac N PLL block 221 may generate an output signal, $o_t$, which may comprise modulated data from the input signal $u_n$ in an FM signal. The Frac N PLL block 221 may generate an output feedback signal, $p_t$, which is communicated to the A/D block 222. The A/D block 222 may generate a representation of the signal, $p_t$, which may be suitable for digital processing. The representation may comprise a sequence of samples that may be encoded using a digital encoding algorithm. The signal reconstruction block 223 may generate a digital waveform signal based on the digital representation generated by the A/D block 222. The digital adaptive algorithm block 224 may compare the digital waveform signal and the input signal $u_n$. Based on the comparison, the digital adaptive algorithm block 224 may generate a subsequent digital control input signal, $c_{n+1}$, which is communicated to the analog Frac N PLL block 221. The output signal $o_t$ and the feedback signal $p_t$ will be affected, while the analog Frac N PLL block 221 may generate a subsequent sampled feedback value $p_{n+1}$ based on a subsequent input signal $u_{n+1}$ the input N, and the subsequent digital control input signal $c_{n+1}$.

One of the limitations in analog Frac N PLL 221 designs is that while larger values of N may theoretically enable more fine-tuned adjustment in the frequency $F(u_n)$ in response to changes in the input signal $u_n$, the larger value of N may introduce phase noise within the analog Frac N PLL 221 circuit, which may limit the precision with which the frequency $F(u_n)$ may change in response to the input signal $u_n$.

In various embodiments of the invention, the digital control input signal, $c_n$, may enable adjustment of circuit parameters within the analog Frac N PLL block 221 based on an output feedback signal $p_t$. The feedback signal $p_t$ may comprise an analog signal. The analog Frac N PLL block 221 may comprise digital.to analog conversion (D/A) circuitry that converts the digital control input signal, $c_n$, to one or more adjustments to values of circuit parameters within the analog circuitry, for example, the voltage controlled oscillator (VCO) gain factor, $K_v$, of the analog Frac N PLL block 221. The VCO gain factor may provide a measure of the responsiveness of changes in the output frequency $F(u_n)$ to changes in the input signal $u_n$.

In an exemplary embodiment of the invention, the output feedback signal, $p_t$, may provide a measure of the responsiveness of changes in the output frequency $F(u_n)$ to changes in the input signal $u_n$. One aspect of the invention comprises a method and system by which values of the analog output feedback signal $p_t$ may be continuously detected, and/or monitored. Based on this continuous monitoring, a digital control input signal $c_n$ may be generated. The analog Frac N PLL block 221 may utilize the digital control input signal to adjust values of circuit parameters within the analog circuitry. In response to the adjustments, a subsequent analog output feedback signal may be generated, from which a subsequent digital control input signal may be generated. This process may be performed continuously during the operation of the analog Frac N PLL block 221.

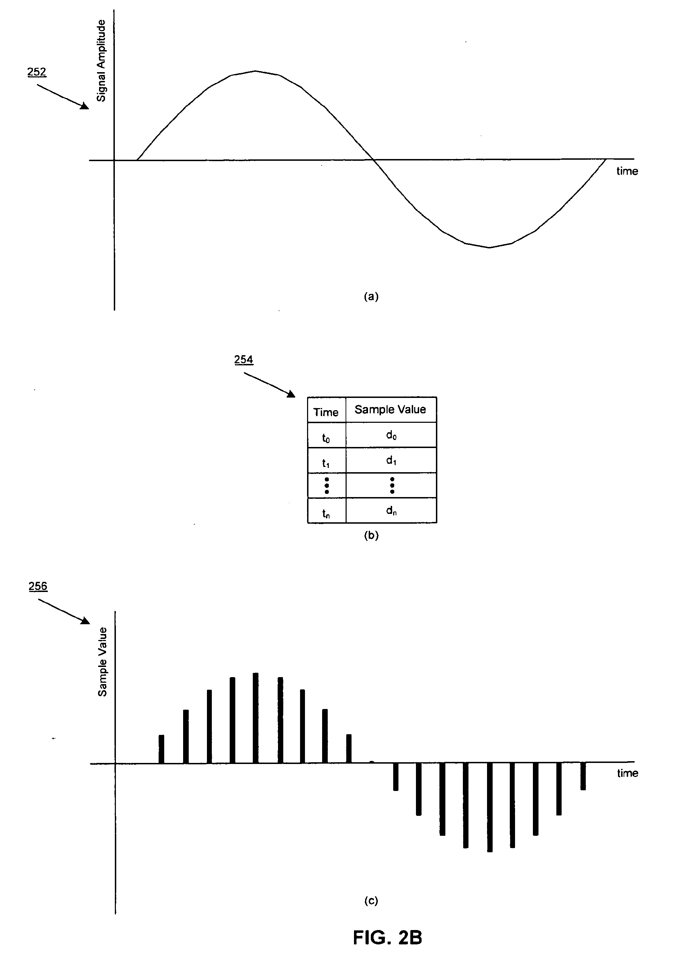

FIG. 2B is a diagram illustrating exemplary A/D signal conversion, which may be utilized in connection with an embodiment of the invention. Referring to FIG. 2B, there is shown an analog signal 252, a digital representation of the analog signal 254, and a digital waveform signal 256. The analog signal 252 represents an exemplary analog output feedback signal $p_t$ (FIG. 2A). The digital representation 254 may be generated by sampling the analog signal 254 at distinct time instants, $t_0$, $t_1$, ..., and $t_n$. The digital waveform signal 256 may represent a digital waveform signal $p_n$. The value of the digital waveform signal 256 may represent the sampled and quantized values of the analog signal 252 at time instants to, $t_1$, ..., and $t_n$.

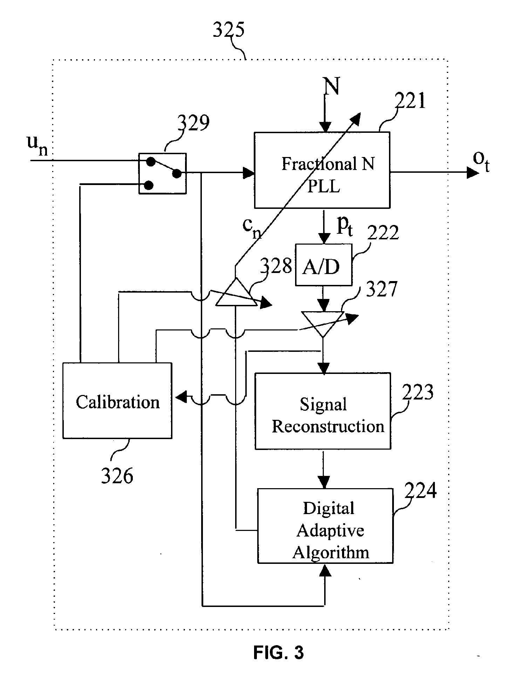

FIG. 3 is a block diagram of an exemplary analog PLL with digital tracking, in accordance with an embodiment of the invention. Referring to FIG. 3, there is shown a PLL 325. The PLL 325 may comprise an analog Frac N PLL block 221, an A/D block 222, a signal reconstruction block 223, a digital adaptive algorithm block 224, a calibration block 326 a plurality of digital amplifiers 327 and 328, and a switch 329. The analog Frac N block 221, A/D block 222, signal reconstruction block 223, and digital adaptive algorithm block 224, may be substantially as described in FIG. 2A.

The calibration block 326 may comprise suitable logic, circuitry, and/or code that may enable generation of signals and reception of a digitized waveform input signal. One or more of the generated signals may be adjusted based on the received digitized waveform input signal.

In operation, during a calibration procedure, the switch 329 may couple an output from the calibration block 326 to an input to the Frac N PLL block 221, and to an input to the digital adaptive algorithm block 224. The processor 125 (FIG. 1A) may generate a signal that may enable the switch 329 to couple the output from the calibration block 326 to the input of the Frac N PLL block 221 and to an input to the digital adaptive algorithm block 224. The calibration block 326 may enable generation of an input signal that may be coupled to an input of the switch 329. The signal may be utilized to generate a calibration output feedback signal $p_t$.

The A/D block 222 may generate a digital output signal based on the feedback signal. The digital amplifier 327 may initially be configured to output an unmodified version of the digital signal received from the A/D block 222, which may be communicated to the calibration block 326. The calibration block 326 may perform measurements on the received digital signal. Based on the measurements, the calibration block may adjust parameters in the digital amplifiers 327 and 328. The adjustments may comprise modifying a value of digital gain for either digital amplifier, both digital amplifiers, or neither digital amplifier.

A modification of the digital gain in the digital amplifier 327 may enable the digital amplifier 327 to receive a digital signal from the A/D block 222, and output a digital signal to the signal reconstruction block 223 in which one or more sample values have been adjusted in comparison corresponding values in the digital signal generated by the A/D block 222. A modification of the digital gain in the digital amplifier 328 may enable the digital amplifier 328 to receive a digital signal from the digital adaptive algorithm block 224, and modify one or more values in the digital signal when generating an output digital control signal $c_n$ to be input to the analog Frac N PLL block 221.

At the end of the calibration procedure, the switch 329 may couple the input signal $u_n$ to the input of the analog Frac N PLL block 221, and to an input to the digital adaptive algorithm block 224. This may represent a configuration for normal circuit operation substantially as described for the PLL 220 in FIG. 2A. The normal circuit operation of the PLL 325 differs from that of the PLL 220 in that for the PLL 325, the digital control signal $c_n$ may be modified based on a digital gain of the digital amplifier 328, which may be determined during calibration. Furthermore, in the PLL 325, the digital signal generated by the A/D block 222 may be modified based on the digital gain of the digital amplifier 327 as determined during the calibration procedure.

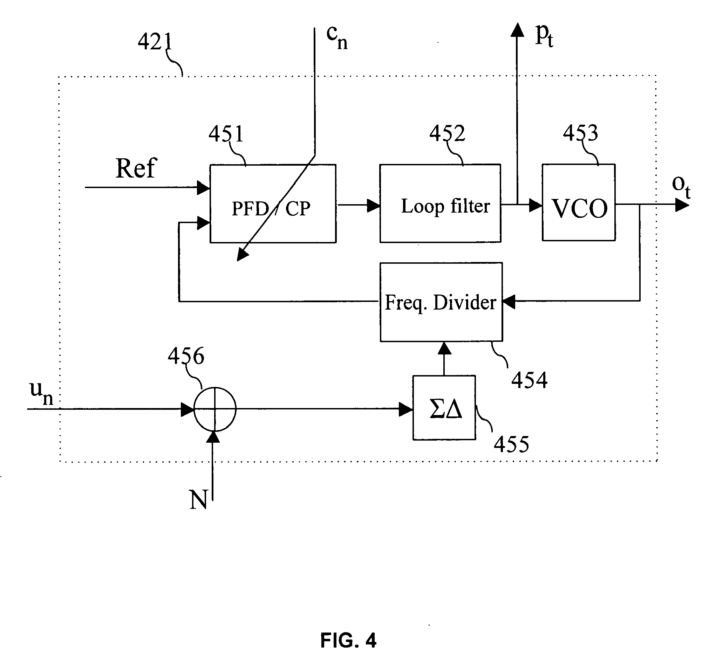

FIG. 4 is a block diagram of an exemplary digitally controlled analog Frac N PLL, in accordance with an embodiment of the invention. Referring to FIG. 4, there is shown, a digitally controlled analog Frac N PLL 421. The digitally controlled analog Frac N PLL 421 may comprise a phase frequency detector and charge pump (PFD/CP) 451, a loop filter 452, a VCO 453, a frequency divider block 454, a sigma-delta modulation ($\Sigma\Delta$) block 455, and an adder block 456.

The PFD/CP block 451 may comprise suitable circuitry, logic, and/or code that may enable generation of a current, i(F), based on a reference input signal, Ref, a feedback signal, and a digital control input signal $c_n$. The variable, F, may be a variable representing a frequency associated with the signal i(F). The Ref signal may be generated by an oscillator crystal. The Ref signal may be defined by a frequency, $F_{Ref}$, amplitude, $A_{Ref}$, and/or phase, $\varphi_{Ref}$. The PFD function within the PFD/CP block 451 may enable detection of phase differences between the Ref signal and the feedback signal at various time instants. The CP function within the PFD/CP block 451 may enable generation of the current i(F) based on the detected phase differences and the digital control input signal $c_n$.

The loop filter 452 may comprise suitable circuitry, logic, and/or code that may be utilized to enable generation of a control voltage signal, $V_{Cntl}$, based on a received current i(F). The loop filter 452 may be characterized by an impedance that may vary as a function of frequency, $Z_{loop}(F)$, where the variable F may represent the frequency associated with the signal i(F). An approximate value for the control voltage $V_{Cntl}$ may be represented as shown in the following equation:

$$V_{Cntl}(F) \cong Z_{loop}(F) \cdot i(F) \qquad \text{Equation [1]}$$

The VCO 453 may comprise suitable circuitry, logic, and/or code that may enable generation of an output signal $o_t$ based on an input control voltage $V_{Cntl}$. The output signal generated by the VCO 453 may be defined by an amplitude, a phase, and/or a frequency. The generated output signal may have a VCO frequency, $F_V$, which may be represented as shown in the following equation:

$$F_V \cong K_V' \cdot V_{cntl} \qquad\qquad \text{Equation [2]}$$

where $K_v$ may represent the VCO gain factor, which may relate an amplitude of the input control voltage, $V_{Cntl}$, to a corresponding frequency of the generated output signal $o_t$.

The frequency divider block 454 may comprise suitable logic, circuitry, and/or code that may enable generation of a feedback signal based on reception of an input signal and an input frequency division number $N_F$. The feedback signal may be defined by an amplitude, $A_{FB}$, a phase, $\varphi_{FB}$, and/or a frequency, $F_{FB}$. For an input signal having a frequency, $F_V$, and for a input division number $N_F$, the frequency divider block 454 may generate a feedback signal having a frequency, $F_{FB}$, which may be represented as shown in the following equation:

$$F_{FB} \cong \frac{F_V}{N_F} \qquad\qquad \text{Equation [3]}$$

The $\Sigma\Delta$ block 455 may comprise suitable logic, circuitry, and/or code that may enable generation of a frequency division number $N_F$ based on a received digital input signal. The frequency division number $N_F$ may comprise an integer component and/or a fractional component. The $\Sigma\Delta$ block 455 may estimate a value for a received digital signal, measure an error when comparing the estimate to the received digital signal, and generate a subsequent estimate based on the current estimate and current computed error. A subsequent value for the frequency division number, $N_F$, output by the $\Sigma\Delta$ block 455 may be based on the value of the subsequent estimate. The $\Sigma\Delta$ block 455 may perform noise shaping on the received digital signal that comprises noise components within a specified frequency range by shifting at least a portion of the noise components to frequencies higher and/or lower than specified frequency range. By performing noise shaping, the $\Sigma\Delta$ block 455 may enable more accurate generation of the frequency division number $N_F$ in response to the received digital signal.

The adder block 456 may comprise suitable logic, circuitry, and/or code that may enable generation of an output digital signal based on an input digital signal $u_n$ and an input N. The input N may represent an index that refers to one of a plurality of frequencies, where the plurality of frequencies may be referred to as a frequency bin. The output digital signal from the adder block may represent the value of the sum $N+u_n$, which may be computed based on binary arithmetic, for example.

In operation, the adder block 456 may receive a digital input signal $u_n$ comprising a sequence of binary values. The adder block 456 may generate a digital signal comprising a sequence of binary values by adding index N to each of the corresponding binary values in the signal $u_n$. The $\Sigma\Delta$ block 455 may generate the frequency division number $N_F$ based on the digital signal received from the adder block 456.

The PFD/CP block 451 may receive an input reference signal, generated by a crystal oscillator, and a feedback signal, generated by the frequency divider block 454. At a given time instant to, the PFD/CP block 451 may compare the signal level of the input reference signal, $A_{Ref}(t_0)$ and the signal level of the feedback signal $A_{FB}(t_0)$. Based on the comparison between the signal levels, $A_{Ref}(t_0)$ and $A_{FB}(t_0)$, a phase and/or frequency difference between the input reference signal and the feedback signal may be detected. Based on the detected phase and/or frequency differences and the current value of the digital control input signal, $c_n$, the PFD/CP block 451 may generate a corresponding current level $i(t_0)$. Based on the current level generated at the current time instant, and probably at one or more preceding time instants, the PFD/CP block 451 may generate a current $i(F)$, where the variable, F, may represent a frequency value.

The loop filter 452 may receive the current $i(F)$ at a time instant $t_0'$, where to' may represent a time instant $t_0+\delta$, and generate a control voltage $V_{cntl}(t_0')$. The control voltage may also be output as an output feedback signal $p_{t_0'}$. The VCO block 453 may receive the control voltage, $V_{cntl}(t_0')$, at a time instant $t_0''$, where $t_0''$ may represent a time instant $t_0'+\delta$. Based on the received control voltage, the VCO block 453 may generate an output signal $o_t$ having a frequency $F_V(t_0'')$.

The frequency divider block 454 may receive the signal $o_t$ at a time instant $t_0'''$, where $t_0'''$ may represent a time instant $t_0''+\delta$. Based on the received $o_t$ signal, and the frequency division number $N_F$ from the $\Sigma\Delta$ block 455, the frequency divider block 454 may generate a feedback signal having a frequency $F_{FB}(t_0''')$, which may be represented as shown in the following equation:

$$F_{FB}\left(t'''\right) \cong \frac{F_v\left(t''\right)}{N_F} \qquad\qquad \text{Equation [4]}$$

The feedback signal generated by the frequency divider block 454 at a time instant $t_0''''$, where $t_0''''$ may represent a time instant $t_0'''+\delta$, may be utilized to generate subsequent output signal $o_{t+1}$.

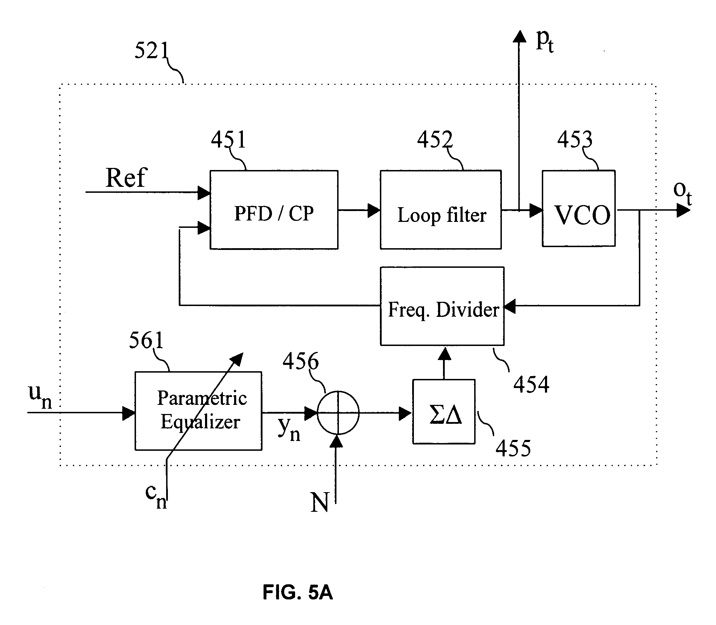

FIG. 5A is a block diagram of an exemplary digitally controlled analog Frac N PLL incorporating a parametric equalizer, in accordance with an embodiment of the invention. Referring to FIG. 5A, there is shown, a digitally controlled analog Frac N PLL 521. The digitally controlled analog Frac N PLL 521 may comprise a PFD/CP 451, a loop filter 452, a VCO 453, a frequency divider block 454, and a $\Sigma\Delta$ block 455, an adder block 456, and a parametric equalizer block 561. The PFD/CP 451, loop filter 452, a VCO 453, frequency divider block 454, $\Sigma\Delta$ block 455, and adder block 456 may be substantially as described in FIG. 4.

The parametric equalizer block 561 may comprise suitable logic, circuitry, and/or code that may enable generation of a digital output signal $y_n$ by filtering of a digital input signal $u_n$. The filtering characteristics of the parametric equalizer block 561 may be configured to control the bandwidth, center frequency, phase and/or pass band gain. The filtering characteristics may be configured to compensate for distortions in the digital input signal $u_n$ due to unequal frequency response in circuitry that generates the input signal due to the closed loop transfer function characteristics of the PLL components 451 to 456, for example. In various embodiments of the invention the filtering characteristics may be configured based on a digital control input signal $c_n$.

In operation, the digitally controlled Frac N PLL circuit 521 may generate an output feedback circuit $p_t$ substantially as described in FIG. 4. A difference between the PLL circuits in FIG. 4 and in FIG. 5A, is that where a digital control mechanism for the Frac N PLL circuit 421 may comprise controlling the of gain in the PFD/CP block 451, a digital control mechanism for the Frac N PLL circuit 521 may comprise controlling the filtering of the digital input signal $u_n$ by controlling filtering parameters in the parametric equalizer block 561.

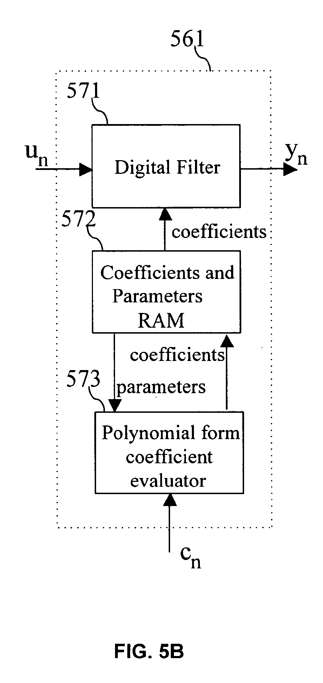

FIG. 5B is a block diagram of an exemplary digitally controlled parametric equalizer circuit, in accordance with an embodiment of the invention. Referring to FIG. 5B, there is shown, a parametric equalizer 561. The parametric equalizer 561 may comprise a digital filter block 571, a memory 572, and a coefficient evaluator block 573.

The digital filter block 571 may comprise suitable logic, circuitry, and/or code that may enable generation of a digital output signal $y_n$ by digital filtering of a digital input signal $u_n$. The filter characteristics, for example the bandwidth, center frequency, and/or pass band gain may be determined adaptively based on input coefficients. In an exemplary embodiment of the invention, the digital filter block 571 may comprise an infinite impulse response (IIR) filter. In various other exemplary embodiments of the invention, the digital filter block 571 may comprise other suitable filtering methods, such as finite impulse response (FIR) filtering, for example.

The memory 572 may comprise suitable logic, circuitry, and/or code that may enable storage of coefficients and parameters that may be utilized in a digitally controlled parametric equalizer circuit. Exemplary parameters may comprise determination of high and/or low pass band frequencies, gain levels, and filter rolloff parameters, which may be utilized to determine how rapidly the gain levels decrease at frequencies above the high pass band frequency and/or at frequencies below the low pass band frequency. Exemplary coefficients may comprise values that may be utilized to determine scale factors for individual taps within an IIR and/or FIR filter implementation, for example. The various scale factors may enable control of the filtering characteristics of the parametric equalizer circuit 561.

The coefficient evaluator block 573 may comprise suitable logic, circuitry, and/or code that may enable computation of values for individual coefficients utilized in the parametric equalizer circuit 561. The coefficient values may be computed based on the digital control input signal $c_n$.

In operation, the coefficient evaluator block 573 may receive a digital control input signal $c_n$. Based on the digital control input signal the coefficient evaluator block 573 may retrieve current parameter values from the memory 572. The current parameter values may be used to evaluate current digital filter coefficient values of the parametric equalizer circuit 561. The coefficient evaluator block 573 may store the generated coefficient values in the memory 572. The digital filter 571 may retrieve a current set of coefficients stored in memory 572 when processing the digital input signal $u_n$. The digital filter 571 may generate a digitally filtered version of the digital input signal $u_n$ where the digital filtering characteristics may be determined based on the coefficients retrieved from the memory 572. The digital filter 571 may generate the digital output signal $y_n$ based on the digitally filtered version of the digital input signal $u_n$.

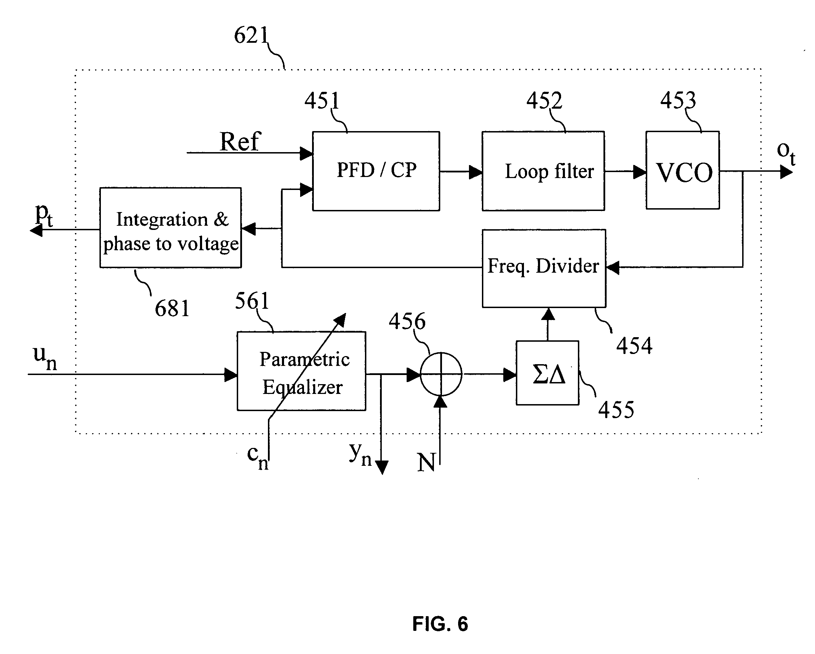

FIG. 6 is a block diagram of an exemplary analog Fractional N (Frac N) PLL incorporating a parametric equalizer that may be digitally controlled based on a feedback signal , in accordance with an embodiment of the invention. Referring to FIG. 6, there is shown, a digitally controlled analog Frac N PLL 621. The digitally controlled analog Frac N PLL 621 may comprise a PFD/CP 451, a loop filter 452, a VCO 453, a frequency divider block 454, and a $\Sigma\Delta$ block 455, an adder block 456, a parametric equalizer block 561, and a signal to voltage block 681. The PFD/CP 451, loop filter 452, a VCO 453, frequency divider block 454, $\Sigma\Delta$ block 455, adder block 456, and parametric equalizer 561 may be substantially as described in FIG. 5A.

The signal to voltage block 681 may comprise suitable logic, circuitry, and/or code to generate an analog output feedback signal $p_t$ based on an analog feedback signal generated by the frequency divider block 454.

In operation, a difference between the PLL circuits in FIG. 5A and in FIG. 6, is that in the Frac N PLL circuit 521, the analog output feedback signal $p_t$ may be generated based on the control voltage to the VCO block 453, $V_{Cntl}$, while in the Frac N PLL circuit 621, the analog output feedback signal may be generated based on the feedback signal generated by the frequency divider block 454.

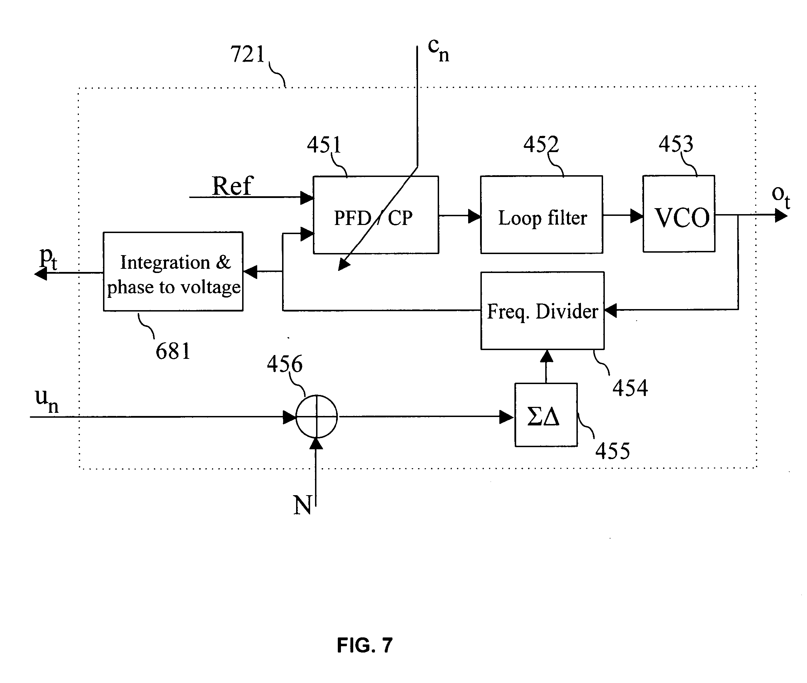

FIG. 7 is a block diagram of an exemplary analog Frac N PLL that may be digitally controlled based on an internal feedback signal, in accordance with an embodiment of the invention. Referring to FIG. 7, there is shown, a digitally controlled analog Frac N PLL 721. The digitally controlled analog Frac N PLL 721 may comprise a PFD/CP 451, a loop filter 452, a VCO 453, a frequency divider block 454, and a $\Sigma\Delta$ block 455, an adder block 456, a parametric equalizer block 561, and a signal to voltage block 681. The PFD/CP 451, loop filter 452, a VCO 453, frequency divider block 454, $\Sigma\Delta$ block 455, adder block 456, parametric equalizer 561, and signal to voltage block 681 may be substantially as described in FIG. 6.

In operation, a difference between the PLL circuits in FIG. 4 and in FIG. 7, is that in the Frac N PLL circuit 421, the analog output feedback signal $p_t$ may be generated based on the control voltage to the VCO block 453, $V_{Cntl}$, while in the Frac N PLL circuit 721, the analog output feedback signal may be generated based on the feedback signal generated by the frequency divider block 454.

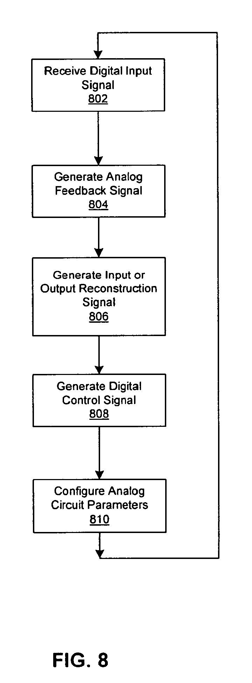

FIG. 8 is a flowchart illustrating exemplary steps for digital tracking control of an analog circuit, in accordance with an embodiment of the invention. Referring to FIG. 8, in step 802, a digital input signal $u_n$ may be applied to an analog PLL circuit 221. In step 804, an analog feedback signal, $p_t$, may be generated and sent to an A/D block 222. In step 806, the output of block 222 may be sent to a signal reconstruction block 223, wherein a reconstructed digital waveform may be sent to the digital adaptive algorithm block 224. In step 808, the digital adaptive algorithm block 224 may generate a digital control signal $c_n$. In step 810, the digital control signal may be sent to the analog circuitry in a Frac N PLL 221 where the circuit parameters may be adjusted based on the received digital control signal. Using the adjusted circuit parameters, step 802 may follow step 810 for processing of subsequent digital input signals.

The bandwidth of a PLL may be the analog quantity we wish to track. This may be represented as $\alpha \cdot b_w$, where $\alpha$ may represent a proportionality constant and $b_w$ may represent a bandwidth parameter. The parameter $b_w$ may be represented as follows:

$$b_w = K_V \cdot K_D \qquad\qquad \text{Equation [5]}$$

where $K_V$ represents the VCO gain factor, and $K_D$ represents a gain factor for the charge pump within the PFD/CP 451. For a given value of $K_V$, the bandwidth parameter may be kept approximately constant, and consequently the bandwidth of the PLL circuit, if:

$$K_D = \frac{b_w}{K_V} \qquad\qquad \text{Equation [6]}$$

With respect to equation [6a], the VCO gain factor may be estimated based on the VCO control voltage, $V_{Cntl}$. Thus, with reference to FIGs. 4 and 7, the digital input control signal $c_n$ may be utilized to control the value of the parameter $K_D$. In this regard, the analog output feedback signal $p_t$ may be used to track variations in the bandwidth parameter $b_w$. In response, the digital input control signal $c_n$ may be generated to adjust the current value of $K_D$ to enable the value of $b_w$ to remain approximately constant.

In an exemplary embodiment of the invention, for the PLL 421 and PLL 721, the transfer function, $H_o(s)$, from the input signal $u_n$ to the output signal $o_t$ may be represented as shown in the following equation:

$$H_o(s) = \frac{Ref \cdot \frac{K_D \cdot K_V}{F(s)}}{1 + \frac{K_D \cdot K_V}{N} \cdot \frac{F(s)}{s}} \qquad\qquad \text{Equation [7]}$$

where Ref represents the reference signal to the PLL, s relates to frequency, F(s) represents the Laplace transform of the loop filter 452, and N represents an index to the frequency bin as indicated in FIGs. 4 and 7.

In an exemplary embodiment of the invention, for the PLL 421, the transfer function, $H_p(s)$, from the input signal $u_n$ to the feedback signal $p_t$ may be represented as in the following equation:

$$H_p(s) = \frac{Ref \cdot \frac{K_D}{N} \cdot F(s)}{1 + \frac{K_D \cdot K_V}{N} \cdot \frac{F(s)}{s}}$$  Equation [8]

Based on equation [8], a reconstructed version, $\hat{u}_t$, of the input signal $u_n$ may be computed from sampled and filtered version of the feedback signal $p_t$ as shown in the following equation:

$$\hat{u}_t = \frac{p_t}{H_p(s)}$$  Equation [9a]

$$\hat{u}_t = \frac{p_t \cdot K_V}{Ref} \left( \frac{N}{b_w \cdot F(s)} + \frac{1}{s} \right)$$  Equation [9b]

Consequently, a digital signal based on the reconstructed version of the input signal may be represented as shown in the following equation:

$$\hat{u}_{n+1}(k) = u_n - A^T \cdot U_n + k \cdot \frac{(p_n + B^T \cdot P_n)}{Ref}$$  Equation [10]

where A and B may represent the denominator and numerator coefficient vectors of the digital equivalent of $\frac{N}{b_w \cdot F(s)}$ and, $U_n$ and $P_n$ may represent delay lines in the PLL input and feedback paths respectively. The value $K_V$ may be computed by minimizing the objective function:

$$J_{n+1}(k) = \left( u_{n+1} - \hat{u}_{n+1}(k) \right)^2$$  Equation [11]

By utilizing a least mean square (LMS) algorithm in connection with equation [11]:

$$k_{n+1} = k_n + \mu \cdot \left( p_{n+1} + B^T \cdot P_{n+1} \right) \cdot \left( u_{n+1} - \hat{u}_{n+1}(k_n) \right)$$  Equation [12]

from equation [6] it may be deduced:

$$c_n = \frac{b_w}{k_n}$$  Equation [13]

In another exemplary embodiment of the invention, the value $K_V$ may be computed by minimizing the objective function:

$$J_{n+1}(k) = \left( u_{n+1} - \frac{\hat{o}_{n+1}(k)}{N} \right)^2 \qquad \text{Equation [14]}$$

where $\hat{O}(s) = N \cdot K_V \cdot P(s)$. Therefore:

$$\hat{o}_n(k) = N \cdot k \cdot p_n \qquad \text{Equation [15]}$$

By utilizing a least mean square (LMS) algorithm in connection with equation [15]:

$$k_{n+1} = k_n + \mu \cdot p_{n+1} \cdot \left( u_{n+1} - \hat{o}_{n+1}(k_n) \right) \qquad \text{Equation [16]}$$

Various embodiments of the invention may also be practiced when values for $c_n$ are computed utilizing a steepest descent algorithm, a conjugate descent algorithm, recursive least squares algorithm, or other suitable digital adaptive algorithms.

When utilizing a steepest descent algorithm, an objective function may be as shown in the following equation:

$$J(k) = E\left[ \left\| u_n - \frac{\hat{o}_n(k)}{N} \right\|^2 \right] \qquad \text{Equation [17a]}$$

$$J(k) = R_{uu}(0) + R_{oo}(0,k) - 2 \cdot R_{uo}(0,k) \qquad \text{Equation [17b]}$$

where E[] denotes an expected value, and $R_{uu}$, $R_{oo}$, and $R_{uo}$ denote auto-correlation and cross-correlation functions. Based on equations [17] a steepest descent update algorithm may be as shown in the following equation:

$$k_n = k_{n+1} + \mu \cdot \left( R_{up}(0,k_{n-1}) - R_{po}(0,k_{n-1}) \right) \qquad \text{Equation [18a]}$$

which may be approximated as shown in the following equation:

$$k_n = k_{n-1} + \frac{\mu}{I} \cdot \sum_{i=1}^{I} p_{n \cdot I + i} \cdot \left( u_{n \cdot I + i} - \frac{\hat{o}_{n \cdot I + i}(k_n)}{N} \right) \qquad \text{Equation [18b]}$$

where I denotes the length of an averaging window.

In practice, both the CP gain factor, $K_D$, and the feedback signal, $p_t$ may have gain errors of $e_D$ and $e_V$ respectively. The error $e_D$ may depend on variations in resistor values in analog PLL circuitry, while $e_V$ may result from variations in A/D converter circuitry. The combined error $e_{VD} = e_V \cdot e_D$ may be estimated by a calibration procedure. As a result of the calibration procedure, at least a portion of the combined error may be cancelled.

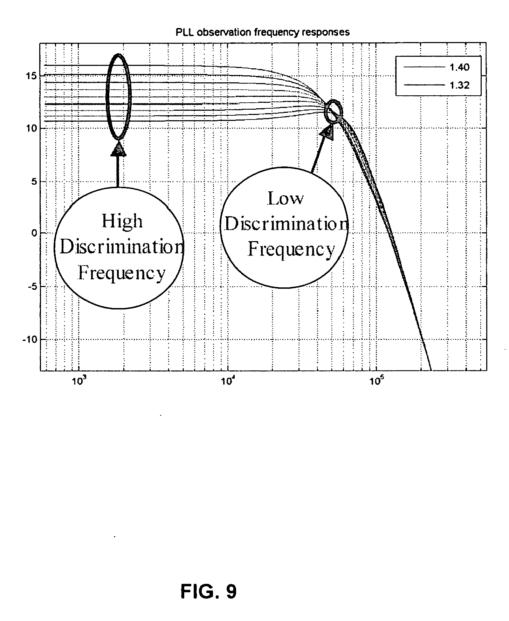

FIG. 9 is a chart illustrating PLL feedback frequency response as a function of $K_V$, which may be utilized in connection with an embodiment of the invention. FIG. 9 shows a power response at a high discrimination frequency (HDF) point, and at a low discrimination frequency (LDF) point. The ratio $\frac{P_{HDF,k}}{P_{LDF,k}}$, where $P_{HDF,k}$ and $P_{LDF,k}$ are power responses at the HDF and LDF points respectively, may be utilized to estimate the bandwidth parameter $b_w$ by comparison with pre-computed values. The resulting estimate $K_1$ may be proportional to $e_D$ and independent of $e_V$. Another estimate of the bandwidth may be obtained using the formula:

$$K_2 = \mathrm{Ref} \cdot dc_{in} / dc_{out} \qquad\qquad \text{Equation [19]}$$

where $dc_{in}$ is the value of a step applied to the PLL input and $dc_{out}$ is the DC value measured at $V_{Cntl}$. $K_2$ is inversely proportional to $e_V$ and independent of $e_D$. The value of $e_{VD}$ may be computed as shown in the following equation:

$$e_{vd} = K_1 / K_2 \qquad\qquad \text{Equation [20]}$$

from which the digital control signal may be computed as shown in the following equation:

$$c_n = bw / (e_{vd} \cdot k_n) \qquad\qquad \text{Equation [21]}$$

The calibration procedure may be extended to track the bandwidth independently of the value $e_V$ by performing tracking based on the DC component of the input signal. In this case, the computed power ratio may be expressed as $\frac{P_{HDF,k}}{P_{LDF,k0}}$, where k0 may represent a fixed reference value for the parameter $b_w$.

During the calibration procedure, a sinusoidal waveform, having a frequency corresponding to the LDF may be generated and the feedback power response $P^c_{ldf,kc}$ measured, where kc is the value of $b_w$ at the time of the calibration procedure. The power responses $P_{lfd,k}$ measured at the LDF may be stored in a table $LUT_{LDF}$ for values of k in the bandwidth range of interest. A sinusoidal waveform having a frequency corresponding to the HDF may be generated and the feedback power response $P^c_{hdf,kc}$ measured. This measurement may be used for updating estimates of kc. A more accurate estimate of the feedback power response at k0 may be computed by using information from the table $LUT_{LDF}$. In turn, the new power estimate may be used to compute a more accurate estimate of kc. The process may be practiced iteratively to reduce estimation error further. The iterative algorithm may be summarized as shown in the following equations:

$$
\begin{aligned}
P^{(0)}_{ldf,k0} &= P^c_{ldf,kc} \\
k_0^{(i)} &= LUT^{-1}_{hdf}\left( P^c_{hdf,kc} / P^{(i-1)}_{ldf,k0} \right) \\
P^{(i)}_{ldf,k0} &= P^{(i-1)}_{ldf,k0} \cdot LUT_{ldf}(k_0) / LUT_{ldf}(k_0^{(i-1)}) 
\end{aligned} \Bigg\} \quad i = 1,2,\ldots,I \qquad \text{Equation [22]}
$$

$$P^c_{ldf,kc} = P^{(I)}_{ldf,k0}$$

Then $n^{th}$ bandwidth value $k_n$ may be generated by a table search as shown in the following equation:

$$k_n = LUT^{-1}_{hdf}\left( P_{out,n} / \left( P_{in,n} P^c_{ldf,kc} \right) \right) \qquad\qquad \text{Equation [23]}$$

where $P_{in,n}$ and $P_{out,n}$ are the input and feedback power calculated during a sufficiently long $n^{th}$ time interval over a low pass range of frequencies.

With reference to FIG. 7, the feedback signal $p_t$ may be generated by the signal to voltage block 681. In this case, the transfer function from the input signal to the feedback signal may be as shown in the following equation:

$$H_p(s) = \frac{\text{Ref}}{s\left(1 + K_d K_v / N \cdot F(s)\right)} \qquad \text{Equation [24]}$$

The Laplace transform of a reconstructed output signal based on the above feedback signal may be as shown in the following equation:

$$\hat{O}(s) = N \cdot \left(\text{Ref} \cdot Y(s) - sP(s)\right) \qquad \text{Equation [25]}$$

where $Y(s)$ refers to the output of the parametric equalizer 561. Consequently, the bandwidth parameter c may be computed based on the error function:

$$J_{n+1}(c) = \left(u_{n+1} - \hat{o}_{n+1}(c)/N\right)^2 \qquad \text{Equation [26a]}$$

where:

$$\hat{o}_{n+1}(c) = N\left(\text{Ref} \cdot y_{n+1}(c) - p_{n+1} + p_n\right) \qquad \text{Equation [26b]}$$

The LMS algorithm for estimating $c_n$ may be as shown in the following equation:

$$c_{n+1} = c_n + \mu \cdot \left(u_{n+1} - \hat{o}_{n+1}(c_n)/N\right)\frac{d}{dc_n} y_{n+1}(c_n) \qquad \text{Equation [27]}$$

With reference to FIG. 6 and FIG. 7, the Laplace transform of the reconstructed output may be represented as shown in the following equation:

$$\hat{O}(s) = K_d K_v sF(s) \cdot P(s) \qquad \text{Equation [28]}$$

Consequently, the digitized reconstructed output may be represented as shown in the following equation:

$$\hat{o}_{n+1}(k) = -A^T \hat{O}_n + kK_d \cdot B^T P_n \qquad \text{Equation [29]}$$

where A and B are denominator and numerator coefficient vectors of the digital equivalent of $sF(s)$ and $\hat{O}_n$, $P_n$ are delay lines in the PLL reconstructed output and feedback paths respectively. $K_V$ may be computed based on the objective function:

$$J_{n+1}(k) = \left(u_{n+1} - \hat{o}_{n+1}(k)/N\right)^2 \qquad \text{Equation [30]}$$

based on the LMS algorithm:

$$k_{n+1} = k_n + \mu \cdot B^T P_{n+1} \left( u_{n+1} - \hat{o}_{n+1}(k_n)/N \right) \qquad \text{Equation [31]}$$

In burst data communication systems such as GSM and EDGE, it may be necessary that the parameter estimates be computed by the beginning of the data burst. In various embodiments of the invention, data acquisition may be combined with calibration procedures as described above. For example, a sinusoidal waveform having a frequency at the HDF point may be generated and the feedback power response $P_{hdf,k}^a$ measured. The acquisition value $c_a$ may be computed by performing a search of the computed lookup table according to the criterion $c_a = LUT_{hdf}^{-1}\left(P_{hdf,k}^a / P_{ldf,kc}^c\right).$

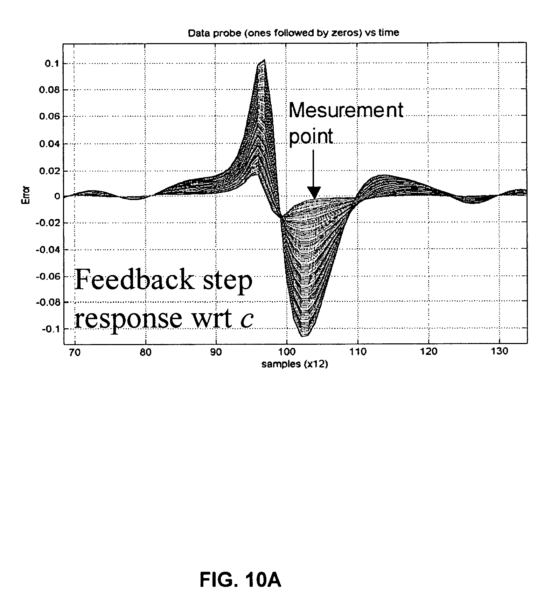

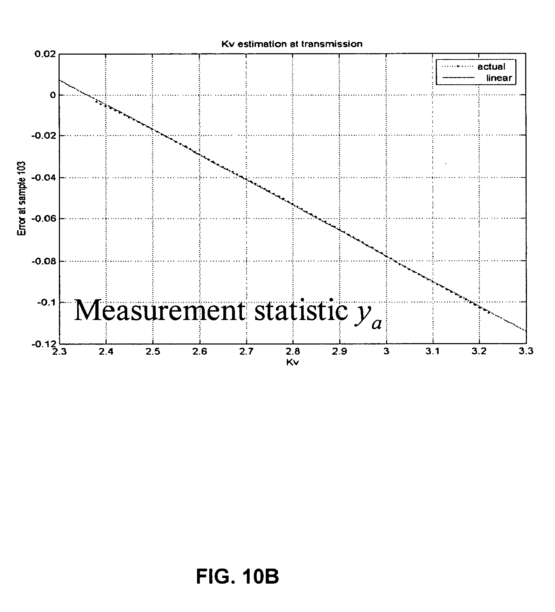

When parametric equalization is utilized, acquisition may be achieved by using a step trigger. FIG. 10A is a diagram illustrating exemplary acquisition of data based on a step response, which may be utilized in connection with an embodiment of the invention. FIG. 10B is a diagram illustrating exemplary values of a measurement statistic, which may be utilized in connection with an embodiment of the invention. FIG. 10B shows the measurement statistic $y_a$, which is based on the phase feedback step response, may be linearly dependent on c and may be used for estimating the acquisition value $c_a = (y_a - \beta)/\alpha$, where $\alpha$ and $\beta$ are constants. Estimating of the constants may be performed during the calibration procedure. For two distinct calibration PLL bandwidths, the associated values of which $c_i$ and $y_i$, may be estimated and used to solve the set of equations for values of $\alpha$ and $\beta$ as shown in the following equation:

$$y_i = \alpha \cdot c_i + \beta, \quad i = 1,2 \qquad \text{Equation [32]}$$

The values $y_i$ for i=1,2 may be computed by using a step trigger. The values $c_i$ for i=1,2 may be computed by inputting a pseudo-random data sequence to the PLL and by using an LMS estimator. Alternatively, $c_i$ for i=1,2 may be estimated using a step trigger in conjunction with the calibration procedure described above. For example, for EDGE and GSM systems, the step trigger may comprise a sequence of five binary 1's followed by five binary 0's.

Analog parameters which may be tracked and/or controlled in various embodiments of the invention may comprise VCO gain $K_v$, charge pump gain $K_D$, PLL bandwidth, PLL control gain (via the digital amplifier 328), feedback gain (via the digital amplifier 327), component capacitance values, and component resistance values. In various embodiments of the invention, more than one parameter may be controlled based on the digital control signal $c_n$. For example, the charge pump gain $K_D$ and filtering characteristics in the parametric equalizer 561 may be simultaneously controlled based on the control signal $c_n$.

Various embodiments of the invention may be practiced in direct modulation and/or polar modulation circuitry, which utilize a variety of PLL designs. These PLL designs may include, for example, PLL designs, which utilize an integer-N PLL, or integer-N synthesizer, a fractional-N PLL, or fractional-N synthesizer, a delta-sigma fractional-N PLL, or delta-sigma fractional-N synthesizer, and/or a hybrid PLL or hybrid synthesizer. Various embodiments of the invention may also be practiced with various 2-input PLL designs.

Aspects of a method and system for digital tracking in direct and polar modulation may comprise at least one circuit within a phase locked loop (PLL) circuit 325 that enables adaptive and digital control of an analog PLL during direct modulation of an input signal or polar modulation of the input signal. The analog PLL may comprise at least a portion of an integer-N PLL, an integer-N synthesizer, a fractional-N PLL, a fractional-N synthesizer, a delta-sigma fractional-N PLL, a delta-sigma fractional-N synthesizer, a hybrid PLL, and/or a hybrid synthesizer. A signal reconstruction block 223 may enable generation of a digital waveform of the input signal for the adaptive and digital control. A digital adaptive algorithm block 224 may enable generation of the digital control signal based on a value of an objective function that may be computed based on the digital waveform and the input signal.

The digital adaptive algorithm block 224 may enable minimization of the objective function by utilizing a least mean square algorithm, a conjugate descent algorithm, and/or a recursive least squares algorithm. The digital adaptive algorithm block 224 within the PLL circuit 325 may enable generation of a digital control signal based on an analog feedback signal generated within the analog Frac N PLL circuit 221, wherein the generated digital control signal may be utilized for the adaptive and digital control. The loop filter block 452 may enable generation of the analog feedback signal based on a control voltage input signal to a voltage control oscillator (VCO) within the analog Frac N PLL circuit 221. The frequency divider block 454 may enable generation of an output signal by a frequency divider circuit within the analog Frac N PLL circuit 221 for the adaptive and digital control.

The adaptive and digital control may comprise adjustment of a VCO gain factor, a charge pump gain factor, a PLL bandwidth parameter, a PLL control gain parameter, a feedback gain parameter, a capacitance value, and/or a resistance value. The adaptive and digital control may comprise adjustment of at least one coefficient in a parametric equalizer circuit 561. The digital adaptive algorithm block 224 may enable configuration of a pass band gain parameter, a filter rolloff parameter, a center frequency parameter, and/or a filter bandwidth parameter, within the parametric equalizer circuit 561 based on the at least one coefficient. The parametric equalizer circuit 561 may comprise a digital circuit that comprises a finite impulse response filter, and/or an infinite impulse response filter.

Accordingly, the present invention may be realized in hardware, software, or a combination of hardware and software. The present invention may be realized in a centralized fashion in at least one computer system, or in a distributed fashion where different elements are spread across several interconnected computer systems. Any kind of computer system or other apparatus adapted for carrying out the methods described herein is suited. A typical combination of hardware and software may be a general-purpose computer system with a computer program that, when being loaded and executed, controls the computer system such that it carries out the methods described herein.

The present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

**Claims**

1. A method for processing signals in a circuit, the method comprising:

   adaptively and digitally controlling an analog phase locked loop (PLL) during direct modulation of a signal or polar modulation of said signal.

2. The method according to claim 1, wherein said analog PLL comprises at least a portion of at least one of: an integer-N PLL, an integer-N synthesizer, a fractional-N PLL, a fractional-N synthesizer, a delta-sigma fractional-N PLL, a delta-sigma fractional-N synthesizer, a hybrid PLL, and a hybrid synthesizer.

3. The method according to claim 1, comprising generating a digital waveform of said signal for said adaptive and digital controlling.

4. The method according to claim 3, comprising generating said digital control signal based on a value of an objective function that is computed based on said digital waveform and said signal.

5. The method according to claim 4, comprising minimizing said objective function by utilizing at least one of: a least mean square algorithm, a conjugate descent algorithm, and a recursive least squares algorithm.

6. The method according to claim 1, comprising generating a digital control signal based on an analog feedback signal generated within said analog PLL circuit, wherein said generated digital control signal is utilized for said adaptive and digital controlling.

7. A system for processing signals in a circuit, the system comprising: at least one circuit that enables adaptive and digital control of an analog phase locked loop (PLL) during direct modulation of a signal or polar modulation of said signal.

8. The system according to claim 7, wherein said analog PLL comprises at least a portion of at least one of: an integer-N PLL, an integer-N synthesizer, a fractional-N PLL, a fractional-N synthesizer, a delta-sigma fractional-N PLL, a delta-sigma fractional-N synthesizer, a hybrid PLL, and a hybrid synthesizer.

9. The system according to claim 7, wherein said at least one circuit enables generation of a digital waveform of said signal for said adaptive and digital control.

10. The system according to claim 9, wherein said at least one circuit enables generation of said digital control signal based on a value of an objective function that is computed based on said digital waveform and said signal.

FIG. 1A

FIG. 1B

FIG. 2A

(a)

| Time | Sample Value |
|------|------|
| $t_0$ | $d_0$ |
| $t_1$ | $d_1$ |
| $\vdots$ | $\vdots$ |
| $t_n$ | $d_n$ |

(b)

(c)

**FIG. 2B**

EP 1 916 763 A1

**FIG. 3**

FIG. 4

**FIG. 5A**

561

$y_n$

Digital Filter

571

coefficients

Coefficients and Parameters RAM

572

coefficients

parameters

Polynomial form coefficient evaluator

573

$c_n$

$u_n$

FIG. 5B

FIG. 6

**FIG. 7**

```
        ┌──────────────────────┐
    ┌──▶│  Receive Digital Input │
    │   │        Signal          │
    │   │         802            │
    │   └──────────────────────┘
    │             │
    │             ▼
    │   ┌──────────────────────┐
    │   │   Generate Analog      │
    │   │   Feedback Signal      │
    │   │         804            │
    │   └──────────────────────┘
    │             │
    │             ▼
    │   ┌──────────────────────┐
    │   │   Generate Input or    │
    │   │ Output Reconstruction  │
    │   │        Signal          │
    │   │         806            │
    │   └──────────────────────┘
    │             │
    │             ▼
    │   ┌──────────────────────┐
    │   │   Generate Digital     │
    │   │   Control Signal       │
    │   │         808            │
    │   └──────────────────────┘
    │             │
    │             ▼
    │   ┌──────────────────────┐
    │   │   Configure Analog     │
    │   │  Circuit Parameters    │
    │   │         810            │
    │   └──────────────────────┘
    │             │
    └─────────────┘
```

**FIG. 8**

FIG. 9

FIG. 10A

EP 1 916 763 A1

**FIG. 10B**

**European Patent Office**

**EUROPEAN SEARCH REPORT**

Application Number

EP 07 01 1820

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 191 653 B1 (CAMP W.) 20 February 2001 (2001-02-20) * column 3, line 8 - column 7, line 12; figures 1-5 * ----- | 1-10 | INV. H03C5/00 |
| A | US 2006/160499 A1 (PUMA G.) 20 July 2006 (2006-07-20) * paragraph [0031] - paragraph [0040]; figure 1 * ----- | 1-10 | |
| A | US 6 211 747 B1 (TRICHET J.) 3 April 2001 (2001-04-03) * column 3, line 25 - column 6, line 37; figure 1 * ----- | 1-10 | |
| A | US 2002/141510 A1 (SRIDHARAN G.) 3 October 2002 (2002-10-03) * paragraph [0021] - paragraph [0040]; figures 2,3 * ----- | 1-10 | |

**TECHNICAL FIELDS SEARCHED (IPC)**

H03C

The present search report has been drawn up for all claims

| Place of search | Date of completion of the search | Examiner |
|---|---|---|
| The Hague | 14 January 2008 | Butler, Nigel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 01 1820

This annex lists the patent family members relating to the patent documents cited in the above-mentioned European search report.
The members are as contained in the European Patent Office EDP file on
The European Patent Office is in no way liable for these particulars which are merely given for the purpose of information.

14-01-2008

| Patent document cited in search report | | Publication date | Patent family member(s) | | Publication date |
|---|---|---|---|---|---|
| US 6191653 | B1 | 20-02-2001 | AT | 248458 T | 15-09-2003 |
| | | | AU | 1713400 A | 05-06-2000 |
| | | | BR | 9915425 A | 07-08-2001 |
| | | | CN | 1326612 A | 12-12-2001 |
| | | | DE | 69910817 D1 | 02-10-2003 |
| | | | EP | 1131885 A1 | 12-09-2001 |
| | | | HK | 1042598 A1 | 07-10-2005 |
| | | | IL | 143166 A | 31-08-2005 |
| | | | JP | 3835735 B2 | 18-10-2006 |
| | | | JP | 2002530917 T | 17-09-2002 |
| | | | JP | 2005184866 A | 07-07-2005 |
| | | | WO | 0030250 A1 | 25-05-2000 |
| US 2006160499 | A1 | 20-07-2006 | CN | 1791086 A | 21-06-2006 |
| | | | DE | 102004060177 B3 | 11-05-2006 |
| | | | EP | 1672861 A2 | 21-06-2006 |
| | | | JP | 2006174464 A | 29-06-2006 |
| US 6211747 | B1 | 03-04-2001 | DE | 69826835 D1 | 11-11-2004 |
| | | | DE | 69826835 T2 | 23-02-2006 |
| | | | EP | 0961412 A1 | 01-12-1999 |
| US 2002141510 | A1 | 03-10-2002 | EP | 1374519 A1 | 02-01-2004 |
| | | | JP | 2004527953 T | 09-09-2004 |
| | | | WO | 02080484 A1 | 10-10-2002 |

EPO FORM P0459

For more details about this annex : see Official Journal of the European Patent Office, No. 12/82